# FASCICULE DE BREVET EUROPEEN

(11) **EP 2 660 862 B1**
(45) Date de publication et mention de la délivrance du brevet: **26.12.2018**
(21) Numéro de dépôt: 13164228.2
(22) Date de dépôt: 18.04.2013
(51) Int. Cl.: H01L 23/66, G06K 19/07

(54) **Dispositif microelectronique de transmission sans fil**
Mikroelektronische drahtlose Übertragungsvorrichtung
Microelectronic wireless transmission device

(30) Priorité: 03.05.2012 FR 1254080
(43) Date de publication de la demande: 06.11.2013
(73) Titulaire: Commissariat à l'Énergie Atomique et aux Énergies Alternatives, 75015 Paris (FR)
(72) Inventeur: Souriau, Jean-Charles, 38120 Saint-Egreve (FR); Castagne, Leaticia, 38600 Fontaine (FR); Parat, Guy-Michel, 38640 Claix (FR)
(74) Mandataire: Ilgart, Jean-Christophe

(56) Documents cités:
- EP-A2- 1 804 075
- US-A1- 2010 193 935
- US-B1- 6 198 392

## Description

### DOMAINE TECHNIQUE

L'invention concerne un dispositif microélectronique de transmission sans fil, fonctionnant de manière autonome. Un tel dispositif est avantageusement muni d'un capteur afin de former une structure de détection autonome apte à transmettre des résultats de mesure par ondes radio. L'invention concerne également un procédé de réalisation d'un tel dispositif microélectronique de transmission sans fil.

### ÉTAT DE LA TECHNIQUE ANTÉRIEURE

Il est connu de réaliser des dispositifs microélectroniques de mesure de type émetteur sans fil. De tels microcapteurs sans fil, donc autonomes, sont réalisés sous la forme de composants de faibles dimensions qui incluent chacun un capteur, un microprocesseur, une source d'énergie et un système de transmission de données. Ils ont pour fonctions de mesurer un ou plusieurs paramètres physiques (température, pression, vibration, CO₂, etc.), de convertir ces mesures en valeurs quantifiables et de les transmettre par ondes radio pour traitement. Un des intérêts de ces microcapteurs est qu'il est possible d'en disséminer un nombre important sans avoir à en assurer la maintenance.

Une partie des éléments du microcapteur sont par exemple réalisés sur une céramique de type HTTC ou LTTC, ou sur un circuit imprimé puis encapsulés dans un polymère. Ces technologies sont toutefois complexes et coûteuses à mettre en oeuvre. De plus, la miniaturisation et la résolution des motifs pouvant être obtenues avec de tels microcapteurs sont limitées. Or, les performances de ces dispositifs aux fréquences d'émission envisagées, comprises entre plusieurs dizaines de MHz et plusieurs dizaines de GHz, sont très sensibles aux facteurs géométriques des dispositifs. De plus, la différence de dilatation thermique entre le support (céramique ou circuit imprimé) et les composants électroniques en silicium peut conduire à des défaillances dans le temps de tels microcapteurs.

Le document US2010193935 décrit un dispositif de transmission radio comprenant une antenne intégrée et un réflecteur réalisé par des plaques métalliques positionnées sur un substrat.

Le document « High-efficiency 60 GHz antenna fabricated using low-cost silicon micromachining techniques » de N. Hoivik et al., Antennas and Propagation Society International Symposium, 2007 IEEE, Honolulu, HI, 9-15 juin 2007, pages 5043 - 5046, décrit un dispositif microélectronique émetteur sans fil dans lequel un circuit intégré et une antenne sont réalisés sur un support de silicium. Ces éléments sont packagés par un capot de silicium reporté sur le support de silicium dans lequel est formée une cavité réflectrice destinée à se trouver en regard de l'antenne et dont la paroi de fond est recouverte de plusieurs couches métalliques.

Par rapport aux dispositifs comprenant un support en céramique ou un circuit imprimé, l'utilisation d'un support en silicium permet d'améliorer la miniaturisation pouvant être réalisée, et donc les performances du dispositif. Par contre, la solution présentée dans ce document nécessite de réaliser un dépôt conforme métallique sur l'ensemble du capot, qui est une étape délicate à mettre en oeuvre et qui implique des risques de microcoupures dans la couche métallique ainsi déposée.

### EXPOSÉ DE L'INVENTION

Un but de la présente invention est de proposer un nouveau type de dispositif microélectronique de transmission sans fil ne présentant pas les inconvénients des dispositifs de l'art antérieur, c'est-à-dire ne présentant pas les inconvénients liés à l'utilisation d'un support en céramique ou d'un circuit imprimé, et ne nécessitant pas la mise en oeuvre de dépôts conformes métalliques.

Pour cela, la présente invention propose un dispositif microélectronique de transmission sans fil comme défini par la revendication 1.

On propose ainsi l'intégration d'un système miniature autonome pouvant communiquer avec l'environnement extérieur par radiofréquences et comprenant un circuit intégré, par exemple un ASIC (« *Application-Specific Integrated Circuit »)* relié électriquement à une source d'alimentation et à une antenne, et un capot dont les fonctions sont de protéger les éléments, ou composants, disposés dans la cavité et de former un réflecteur d'ondes radio. Le capot est composé de, ou comprend, un ou plusieurs matériaux électriquement conducteurs et est relié à un potentiel électrique de l'alimentation électrique et/ou du circuit intégré afin de remplir la fonction de réflecteur d'ondes.

Le matériau électriquement conducteur du capot est avantageusement du silicium fortement dopé (par exemple d'environ 1 mOhm.cm à quelques dizaines de mOhm.cm, ou entre environ 1 et 100 mOhm.cm).

Le dispositif microélectronique peut comporter des dimensions millimétriques, la bande de fréquences de communication du dispositif pouvant se situer autour de 60 GHz.

Le circuit intégré et l'antenne peuvent être disposés dans deux cavités distinctes formées entre le capot et le substrat. Une telle configuration peut être avantageuse pour éviter que le circuit intégré perturbe l'antenne, ou que le circuit intégré ne soit perturbé par l'antenne. Dans ce cas, des liaisons électriques entre le circuit intégré et l'antenne peuvent passer d'une cavité à l'autre.

En variante, il est également possible que le circuit intégré et l'antenne soient disposés dans deux parties d'une même cavité qui sont séparées l'une de l'autre par un écran électromagnétique, un tel écran permettant d'éviter des perturbations électromagnétiques entre le circuit intégré et l'antenne. Dans ce cas, des liaisons électriques entre le circuit intégré et l'antenne peuvent passer sous l'écran électromagnétique.

Le substrat apte à être traversé par des ondes radio peut être composé de, ou comprendre, un ou plusieurs matériaux aptes à être traversés par lesdites ondes radio, comme par exemple du silicium non dopé, du SiO₂, du polymère. En variante, il est possible qu'une partie seulement du substrat soit composée de, ou comprenne, un ou plusieurs matériaux aptes à être traversés par les ondes radio. Cette partie du substrat forme une « fenêtre » à travers laquelle les ondes radio peuvent être émises.

L'alimentation électrique peut comporter au moins une microbatterie et/ou être disposée dans la cavité ou une des cavités.

Les liaisons électriques entre le circuit intégré et l'antenne, entre le circuit intégré et l'alimentation électrique, et entre le capot et l'alimentation électrique, peuvent comporter des fils et/ou des pistes électriquement conductrices disposées sur le substrat.

Les pistes électriquement conductrices peuvent être composées de, ou comprendre, au moins un matériau électriquement conducteur, avantageusement un matériau métallique, similaire à au moins un matériau électriquement conducteur de l'antenne. Ainsi, les pistes électriquement conductrices peuvent être réalisées à partir d'une ou plusieurs couches métalliques servant également à réaliser l'antenne.

Les parois latérales de la cavité peuvent être formées par le capot.

Le capot peut être solidarisé au substrat par au moins un cordon de scellement composé de, ou comprenant, au moins un matériau électriquement conducteur.

Dans ce cas, l'alimentation électrique et/ou le circuit intégré peut être relié électriquement au cordon de scellement qui est en contact avec le capot. Ainsi, le capot peut être relié électriquement à un potentiel électrique de l'alimentation électrique et/ou du circuit intégré via le cordon de scellement.

Le cordon de scellement peut être composé de, ou comprendre, au moins un matériau métallique similaire à au moins un matériau métallique de l'antenne. Ainsi, le cordon de scellement peut être réalisé à partir d'une ou plusieurs couches métalliques servant également à réaliser l'antenne.

Le dispositif peut comporter en outre au moins un capteur disposé dans la cavité ou une des cavités et relié électriquement au circuit intégré tel que le capteur puisse être apte à transmettre au moins un signal de mesure au circuit intégré, au moins une partie des signaux électriques transmis par le circuit intégré à l'antenne pouvant être fonction du signal de mesure transmis au circuit intégré par le capteur. Dans une telle configuration où un capteur est encapsulé dans la cavité, les applications visées peuvent être celles où des mesures physiques sont réalisées sans contact direct avec l'extérieur, par exemple la mesure d'une vibration ou d'un rayonnement. Un tel dispositif microélectronique peut répondre à des besoins dans les domaines de l'industrie, du transport, de l'habitat et de la sécurité, par exemple pour anticiper la défaillance de pièces mécaniques par la surveillance des vibrations. Un tel dispositif peut également correspondre à un dispositif médical permettant la surveillance de l'activité cardiaque (par exemple disposé à l'extrémité d'une sonde de stimulation cardiaque).

Un tel dispositif peut comporter en outre au moins un dispositif de récupération d'énergie couplé électriquement à l'alimentation électrique.

L'invention concerne également un procédé de réalisation d'un dispositif microélectronique de transmission sans comme défini par la revendication 12.

Le terme « intégration » désigne ici la réalisation par report et/ou par formation desdits éléments précités sur le substrat.

Le procédé peut comporter au moins, avant l'intégration de l'alimentation électrique et du circuit intégré, des étapes de dépôt, photolithographie et gravure d'au moins une couche électriquement conductrice sur le substrat, formant l'antenne et des pistes électriquement conductrices, le circuit intégré et l'alimentation électrique pouvant être reliés à au moins une partie des pistes électriquement conductrices par des microbilles (par exemple composées de matériau fusible) ou des liaisons filaires, les pistes électriquement conductrices formant au moins une partie des liaisons électriques entre le circuit intégré et l'antenne, entre le circuit intégré et l'alimentation électrique, et entre le capot et l'alimentation électrique et/ou le circuit intégré.

Les étapes de dépôt, photolithographie et gravure de ladite au moins une couche électriquement conductrice sur le substrat peuvent former également au moins une partie d'un cordon de scellement, le capot étant solidarisé au substrat par le cordon de scellement.

Le procédé peut comporter en outre l'intégration (c'est-à-dire la réalisation par report et/ou par formation sur le substrat) d'un capteur tel qu'il soit disposé dans la cavité et relié électriquement au circuit intégré, le capteur étant apte à transmettre au moins un signal de mesure au circuit intégré, au moins une partie des signaux électriques transmis par le circuit intégré à l'antenne étant fonction du signal de mesure transmis au circuit intégré par le capteur.

Le procédé peut comporter en outre au moins l'intégration (c'est-à-dire la réalisation par report et/ou par formation sur le substrat) d'un dispositif de récupération d'énergie couplé électriquement à l'alimentation électrique.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- la figure 1 représente une vue en coupe de profil d'un dispositif microélectronique de transmission sans fil, objet de la présente invention, selon un premier mode de réalisation,
- les figures 2A et 2B représentent des vues en coupe de profil et de dessus d'un dispositif microélectronique de transmission sans fil, objet de la présente invention, selon un deuxième mode de réalisation,
- la figure 3 représente une vue en coupe de profil d'un dispositif microélectronique de transmission sans fil, objet de la présente invention, selon un troisième mode de réalisation,
- les figures 4A et 4B représentent des vues en coupe de profil et de dessus d'un dispositif microélectronique de transmission sans fil, objet de la présente invention, selon un quatrième mode de réalisation,
- les figures 5A et 5B représentent des vues en coupe de profil et de dessus d'un dispositif microélectronique de transmission sans fil, objet de la présente invention, selon un cinquième mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

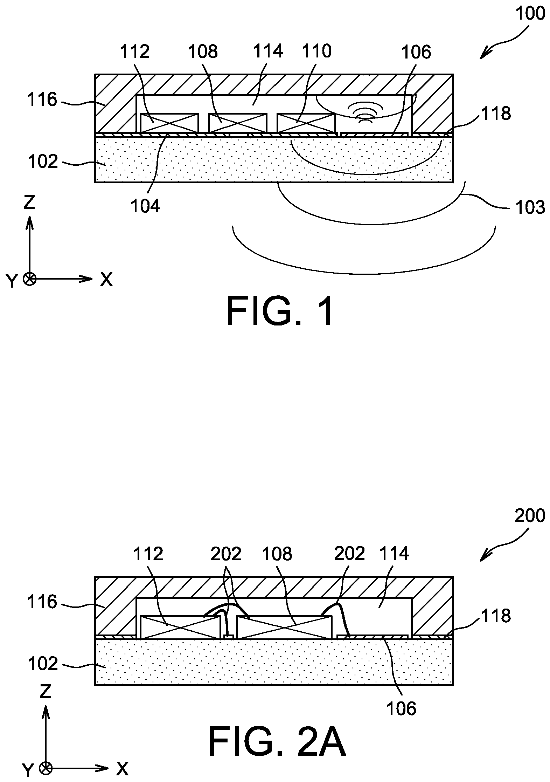

On se réfère tout d'abord à la figure 1 qui représente une vue en coupe de profil d'un dispositif microélectronique de transmission sans fil 100 selon un premier mode de réalisation.

Le dispositif 100 comporte un substrat 102 sur lequel différents composants, ou éléments, du dispositif 100 sont réalisés, ou intégrés. Le ou les matériaux du substrat 102 sont ici choisis tels que les ondes radio (représentées symboliquement sur la figure 1 et portant la référence 103) destinées à être émises par le dispositif 100 puissent traverser le substrat 102. Dans ce premier mode de réalisation, le substrat 102 est composé de, ou comprend du, silicium et/ou de verre et/ou de polymère. L'épaisseur (dimension selon l'axe Z) du substrat 102 est par exemple comprise entre environ 50 µm et 500 µm. La longueur (dimension selon l'axe X) du substrat 102, qui peut être égale à la longueur totale du dispositif 100, et/ou la largeur (dimension selon l'axe Y) du substrat 102, qui peut être égale à la largeur totale du dispositif 100, sont par exemple comprises entre environ 0,5 mm et 20 mm.

Plusieurs pistes électriquement conductrices 104, par exemple composées de, ou comprenant, un ou plusieurs métaux, sont réalisées sur la face avant du substrat 102 sur laquelle les différents composants du dispositif 100 sont disposés. Ces pistes électriquement conductrices 104 permettent notamment de relier électriquement les composants du dispositif 100 entre eux. Les pistes électriquement conductrices 104 sont réalisées à partir d'une ou plusieurs couches métalliques déposées sur le substrat 102, par exemple par voie électrolytique, par dépôt plasma (par exemple de type PECVD, c'est-à-dire un dépôt chimique en phase vapeur assisté par plasma) ou par évaporation. Cette ou ces couches métalliques sont soumises ensuite à une ou plusieurs étapes de photolithographie et de gravure humide et/ou sèche selon le motif souhaité. Ces couches métalliques sont par exemple composées de, ou comprennent du, titane et/ou de nitrure de tungstène et/ou de nickel et/ou d'aluminium et/ou de cuivre et/ou d'or. Les pistes électriquement conductrices 104 ont une épaisseur par exemple comprise entre environ 100 nm et 5 µm. Enfin, les pistes 104 sont disjointes pour être isolées électriquement les unes des autres. Les pistes 104 sont en outre avantageusement déposées sur une couche de matériau diélectrique, par exemple un oxyde tel que du SiO₂ et/ou un polymère, disposée sur la face avant du substrat 102 lorsque celui-ci est électriquement conducteur. De plus, les pistes 104 peuvent être recouvertes d'un dépôt d'une couche électriquement isolante par exemple composée d'un oxyde de silicium ou d'un polymère.

De manière avantageuse, le motif de la ou des couches métalliques déposées sur le substrat 102 et gravées inclut, outre les pistes électriquement conductrices 104, une partie apte à former une antenne 106 du dispositif 100 apte à émettre et éventuellement recevoir des ondes radio. La surface occupée par l'antenne 106 sur le substrat 102 dépend notamment de la ou des fréquences des ondes radio destinées à être émises et éventuellement reçues par le dispositif 100. Par exemple, pour réaliser une émission d'ondes à environ 60 GHz, la surface de l'antenne 106 peut être comprise entre environ 0,01 mm² et quelques mm², c'est-à-dire moins de 10 mm². De plus, pour une telle fréquence d'émission, l'antenne 106 peut avoir une longueur égale à environ 2,5 mm.

Des composants du dispositif 100 sont reportés par « Flip-Chip » du côté de la face avant du substrat 102 (les faces actives de ces composants qui comportent des contacts électriques se trouvant du côté de la face avant du substrat 102), notamment sur les pistes électriquement conductrices 104 et/ou sur des plots d'accueil métalliques, au moins une partie de ces plots d'accueil étant reliés électriquement aux pistes électriquement conductrices 104. Ce report, réalisé via des microbilles de matériau fusible par exemple composées de, ou comprenant du, SnAgCu et/ou de SnAu et/ou d'indium ou via des micro-inserts par exemple composés de, ou comprenant du, nickel, permet de solidariser mécaniquement les composants du dispositif 100 au substrat 102, et également de les relier électriquement entre eux et/ou à d'autres éléments du dispositif 100.

Ces composants du dispositif 100 correspondent à un circuit intégré 108, par exemple de type ASIC, un capteur 110, par exemple de type MEMS et/ou NEMS, et une alimentation électrique 112 réalisée ici sous la forme d'une microbatterie. Le capteur 110 est destiné à mesurer un ou plusieurs paramètres physiques (par exemple une vibration et/ou un rayonnement extérieurs au dispositif 100). Afin de pouvoir transmettre par ondes radio des signaux en fonction de la ou des mesures réalisées par le capteur 110, le capteur 110 est relié électriquement au circuit intégré 108 via une ou plusieurs des pistes électriquement conductrices 104. Les mesures réalisées par le capteur 110 sont ainsi transmises au circuit intégré 108 via ces pistes 104. Le circuit intégré 108, qui correspond par exemple à un microprocesseur de type ASIC, peut par exemple transformer ces mesures en valeurs quantifiables et délivrer en sortie des signaux électriques correspondant à ces mesures. Le circuit intégré 108 est relié électriquement à l'antenne 106 par une ou plusieurs pistes électriquement conductrices 104, les signaux de sortie du circuit intégré 108 étant transmis à l'antenne 106 via cette ou ces pistes 104. Les signaux de sortie du circuit intégré 108 peuvent correspondre aux mesures réalisées par le capteur 110, ou plus généralement être fonction des valeurs de mesure réalisées (il est possible que le dispositif 100 émette par ondes radios des informations ne correspondant pas directement aux mesures réalisées par le capteur 110, mais par exemple dont l'envoi est conditionné par une certaine valeur de mesure). L'antenne 106 émet ensuite les ondes radio 103 qui correspondent aux signaux envoyés par le circuit intégré 108.

L'alimentation électrique du circuit intégré 108 est assurée par la microbatterie 112, ces deux éléments étant reliés électriquement l'un à l'autre par une ou plusieurs des pistes électriquement conductrices 104. Une telle microbatterie 112 forme un système d'alimentation électrique peu encombrant, capable de délivrer des pics de puissance suffisants notamment lors de la transmission de l'information par l'antenne 106, et d'assurer une grande autonomie (pendant plusieurs années) du dispositif 100. Une telle microbatterie comporte une architecture tout solide présentant les propriétés suivantes : longue durée de vie, nombre de cycles charge/décharge élevé, peu d'autodécharge, rendement énergétique élevé, faible volume. Du fait de son architecture tout solide et des matériaux employés (comprenant par exemple un électrolyte solide inorganique), l'utilisation d'une telle microbatterie 112 dans le dispositif 100 qui est destiné à fonctionner de manière autonome pendant une longue durée d'utilisation est particulièrement avantageuse. Une telle microbatterie est décrite par exemple dans le document « Microbatteries : microsources d'énergie en couches minces » de Levasseur A., Pecquenard B., Vinatier P., Salot R., Le Cras F. et Martin M., Techniques de l'Ingénieur. Energie 2009, n° D3342.

Bien que l'utilisation de la microbatterie 112 dans le dispositif 100 soit particulièrement avantageuse, la fonction d'alimentation électrique des composants du dispositif 100 peut être remplie par n'importe quelle alimentation électrique de type accumulateur assurant une alimentation électrique autonome des éléments du dispositif 100.

Dans le dispositif 100 décrit en liaison avec la figure 1, tous les composants du dispositif 100 sont encapsulés dans une cavité 114 formée entre le substrat 102 et un capot 116. Le capot 116 est ici composé de silicium qui est électriquement conducteur en raison d'un fort dopage, et dans lequel la cavité 114 est gravée au préalable. Le capot 116 peut être composé de, ou comprendre, n'importe quel matériau électriquement conducteur, par exemple un métal ou un alliage métallique. Toutefois, pour des raisons de dilatation thermique, on réalise avantageusement le capot 116 et le substrat 102 à partir de matériaux ayant des coefficients de dilatation thermique proches ou similaires, par exemple en silicium. Le capot 116 est solidarisé au substrat 102 via un cordon de scellement 118, dont au moins une partie est par exemple issue des couches métalliques ayant servies à réaliser les pistes électriquement conductrices 104 ainsi que l'antenne 106, réalisé autour des éléments 106, 108, 110 et 112 du dispositif 100. Le motif de la ou des couches métalliques déposées sur le substrat 102 et gravées inclut donc, outre les pistes conductrices 104 et l'antenne 106, le cordon de scellement 118. Le capot 116 a par exemple une épaisseur (dimension selon l'axe Z) comprise entre environ 50 µm et 500 µm. La longueur (dimension selon l'axe X) du capot 116, qui peut être égale à la longueur totale du dispositif 100, et/ou la largeur (dimension selon l'axe Y) du capot 116, qui peut être égale également à la largeur totale du dispositif 100, sont par exemple comprises entre environ 0,5 mm et 20 mm. Sur l'exemple de la figure 1, la longueur et la largeur du capot 116 sont sensiblement similaires à celles du substrat 102, et correspondent à la longueur et la largeur totales du dispositif 100.

Le ou les matériaux du cordon de scellement 118 sont choisis tels qu'ils permettent d'assurer à la fois un lien mécanique entre le substrat 102 et le capot 116, et un lien électrique avec le capot 116. Le cordon de scellement 118 est par exemple composé de, ou comprenant du, titane et/ou de chrome et/ou de nitrure de tungstène et/ou de nickel et/ou d'or et/ou d'un alliage d'or et d'étain et/ou d'un alliage d'or et de silicium. Le cordon de scellement 118 a par exemple une épaisseur comprise entre environ 100 nm et 5 µm, et une largeur comprise entre environ 10 µm et 1 mm.

Outre la fonction de protection mécanique des composants remplie par le capot 116, le fait que le capot 116 soit composé d'un matériau électriquement conducteur lui permet également de remplir la fonction de réflecteur vis-à-vis des ondes radio émises par l'antenne 106. Ainsi, les ondes radio émises depuis l'antenne 106 dans la cavité 114 sont réfléchies par le capot 116, ces ondes réfléchies étant émises à l'extérieur en traversant ensuite le substrat 102. Afin que le capot 116 puisse remplir cette fonction de réflecteur, celui-ci est relié électriquement à un potentiel électrique de référence. Dans le dispositif 100, ce potentiel de référence correspond à l'un des potentiels électriques de la microbatterie 112. Pour réaliser cette liaison, la microbatterie 112 est reliée électriquement à une des pistes conductrices 104 qui est elle-même reliée électriquement au cordon de scellement 118. Du fait que le cordon de scellement 118 et le capot 116 soient tous les deux électriquement conducteurs et en contact l'un avec l'autre, le capot 116 est donc bien relié électriquement à l'un des potentiels électriques de la microbatterie 112. En variante, le potentiel électrique de référence auquel est relié électriquement le capot 116 peut correspondre à un potentiel électrique du circuit intégré 108. Dans ce cas, le circuit intégré 108 est relié électriquement à une des pistes conductrices 104 qui est elle-même reliée électriquement au cordon de scellement 118.

Pour que le capot 116 remplisse sa fonction de réflecteur, la cavité 114 dans laquelle est disposée l'antenne 106 est dimensionnée afin qu'un espace (dans lequel les ondes peuvent se propager) soit présent entre l'antenne 106 et la paroi de la cavité 114 se trouvant en regard de l'antenne 106 (cette paroi étant formée par le capot 116). La hauteur de cet espace entre le capot 116 et l'antenne 106 dépend notamment de la permittivité de l'élément, ou matériau, se trouvant entre l'antenne 106 et le capot 116. Lorsque de l'air sépare l'antenne 106 du capot 116, comme c'est le cas sur l'exemple de la figure 1, cette hauteur est égale à un multiple de *λ*, et avantageusement *λ*/*4*, *λ* correspondant à la longueur d'ondes des ondes destinées à être émises. Pour réduire cette distance, il est possible de déposer sur l'antenne 106 ou contre le capot 116, à l'intérieur de la cavité 114, un diélectrique ayant une permittivité plus élevée que celle de l'air. Dans le cas d'un dispositif 100 apte à émettre des ondes de fréquence égale à environ 60 GHz, cette distance entre l'antenne 106 et la paroi de la cavité 114 formée par le capot 116 en regard de l'antenne 106 est par exemple comprise entre environ 200 µm et 1500 µm.

Le capot 116 est par exemple réalisé à partir d'un second substrat par exemple composé de, ou comprenant du, semi-conducteur tel que du silicium fortement dopé. On réalise tout d'abord, sur une face du second substrat destinée à se trouver du côté du substrat 102, un dépôt (par exemple par voie électrolytique, par dépôt plasma ou par évaporation) et une structuration d'une ou plusieurs couches métalliques destinées à former au moins une partie du cordon de scellement 118. Un traitement thermique peut ensuite être réalisé afin de diffuser des espèces métalliques (issues des couches métalliques déposées) dans le matériau du second substrat, et améliorer ainsi le contact électrique entre le ou les matériaux métalliques déposés et le second substrat. La cavité 114 est ensuite formée dans le second substrat, par exemple par gravure chimique à partir d'une solution de KOH et/ou de TMAH, ou par gravure plasma de type DRIE (gravure ionique réactive profonde), achevant ainsi la réalisation du capot 116. Une gravure de type DRIE a notamment pour avantage de former la cavité 114 telle qu'elle présente des flancs latéraux bien droits. En fonction de la profondeur de gravure à réaliser, c'est-à-dire de la hauteur de la cavité 114, la gravure du second substrat peut être réalisée à travers un masque de résine photosensible et/ou un masque d'oxyde.

Le capot 116 est ensuite solidarisé au substrat 102, de préférence à l'échelle du wafer afin de réaliser simultanément l'encapsulation de composants de plusieurs dispositifs similaires au dispositif 100. Cette solidarisation peut toutefois être réalisée à l'échelle de la puce (qui correspond au dispositif 100 seul). La solidarisation est par exemple réalisée via une fusion et/ou une thermocompression dont les paramètres (température, pression, etc.) sont fonction notamment de la nature des matériaux formant le cordon de scellement 118. Dans l'exemple décrit précédemment, on réalise donc une thermocompression entre le ou les matériaux métalliques présents sur le capot 116 et le ou les matériaux métalliques présents sur le substrat 102, ces matériaux ayant été gravés selon le motif du cordon de scellement 118 souhaité.

Lors de la réalisation du dispositif 100, il peut être avantageux dans certains cas de séparer la fabrication des pistes électriquement conductrices 104 de la fabrication de l'antenne 106 et/ou de celle du cordon de scellement 118 afin d'utiliser différents matériaux et/ou différentes épaisseurs de matériaux pour ces différents éléments. De même, des plots métalliques d'accueils pour les microbilles de matériau fusible servant à solidariser la microbatterie 112, le circuit intégré 108 et le capteur 110 peuvent être réalisés indépendamment de ces éléments. De plus, il est possible de réaliser un amincissement et un polissage de la face arrière du substrat 102 si l'on souhaite réduire l'épaisseur initiale du substrat 102.

En variante, il est possible qu'une partie seulement du substrat 102 se trouvant en regard de l'antenne 106 soit composée de, ou comprenne, un ou plusieurs matériaux aptes à être traversés par les ondes radio. Cette partie du substrat 102 forme dans ce cas une fenêtre à travers laquelle les ondes radio peuvent être émises.

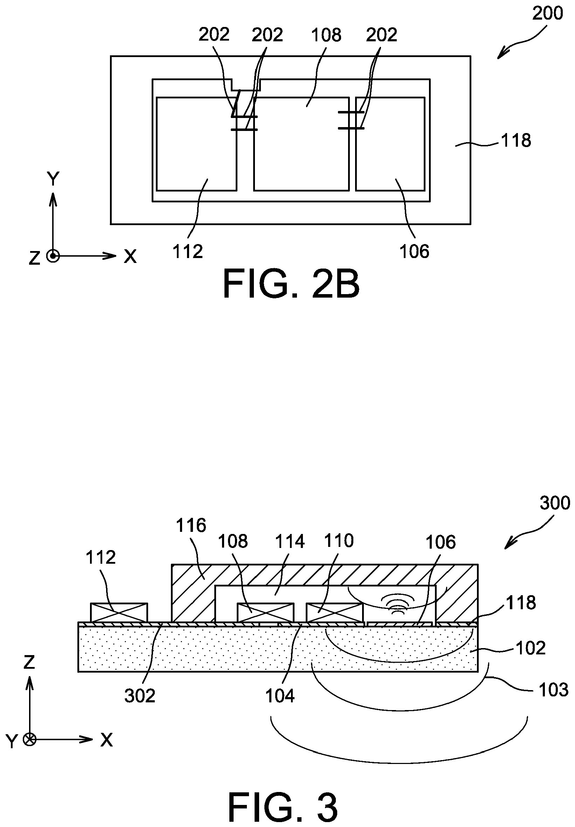

Le dispositif 100 précédemment décrit correspond à un dispositif microélectronique émetteur sans fil apte à réaliser une mesure d'un paramètre via le capteur 110, et à transmettre cette mesure par ondes radio. En variante, un tel dispositif microélectronique émetteur sans fil peut ne pas comporter cette fonction de mesure, et servir uniquement à réaliser une transmission (émission et éventuellement réception) de données par ondes radio. Un deuxième mode de réalisation d'un dispositif microélectronique émetteur sans fil 200 est représenté sur les figures 2A et 2B correspondant respectivement à des vues en coupe de profil et de dessus du dispositif 200.

Contrairement au dispositif 100, le dispositif 200 ne comporte pas d'élément ou de composant permettant au dispositif de réaliser une mesure. Ainsi, le dispositif 200 comporte le substrat 102 sur lequel sont disposés l'antenne 106, le circuit intégré 108 et l'alimentation électrique formée par la microbatterie 112. Ces éléments sont encapsulés dans la cavité 114 formée entre le capot 116 électriquement conducteur et le substrat 102 qui sont solidarisés l'un à l'autre par le cordon de scellement 118. Comme dans le dispositif 100, la microbatterie 112 est reliée électriquement au circuit intégré 108 afin d'alimenter électriquement le circuit intégré 108. Le circuit intégré 108 est également relié électriquement à l'antenne 106 afin de transmettre les données à émettre par ondes radio.

De plus, contrairement au dispositif 100 dans lequel les composants (alimentation électrique 112, capteur 110 et circuit intégré 108) et sont reliés mécaniquement au substrat 102 et électriquement aux pistes conductrices 104 par des microbilles métalliques (report par « Flip-chip »), les composants du dispositif 200 sont solidarisés, par exemple par collage, directement contre le substrat 102 et non sur des parties métalliques présentes sur le substrat via des microbilles de matériau fusible. Dans le dispositif 200, ce sont les faces arrières du circuit intégré 108 et de l'alimentation électrique 112, c'est-à-dire celles ne comportant pas les accès électriques à ces composants, qui sont solidarisées contre le substrat 102. Au moins une partie des liaisons électriques entre l'alimentation 112 et le circuit intégré 108, entre le circuit intégré 108 et l'antenne 106 et entre l'un des potentiels électriques de l'alimentation 112 et le cordon de scellement 118 sont réalisées non pas par des pistes électriquement conductrices, mais par des fils électriques 202 câblés entre ces éléments.

La figure 3 représente un dispositif microélectronique émetteur sans fil 300 selon un troisième mode de réalisation.

Le dispositif 300 comporte tous les éléments du dispositif 100 précédemment décrit, c'est-à-dire le substrat 102, les pistes conductrices 104, l'antenne 106, le circuit intégré 108, le capteur 110, l'alimentation électrique 112, la cavité 114, le capot 116 et le cordon de scellement 118. Toutefois, contrairement au dispositif 100, l'alimentation électrique 112, qui correspond par exemple à une microbatterie, est disposée sur le substrat 102 en dehors de la cavité 114. Seuls le capteur 110, l'antenne 106 et le circuit intégré 108 sont protégés par le capot conducteur 116 et disposés dans la cavité 114.

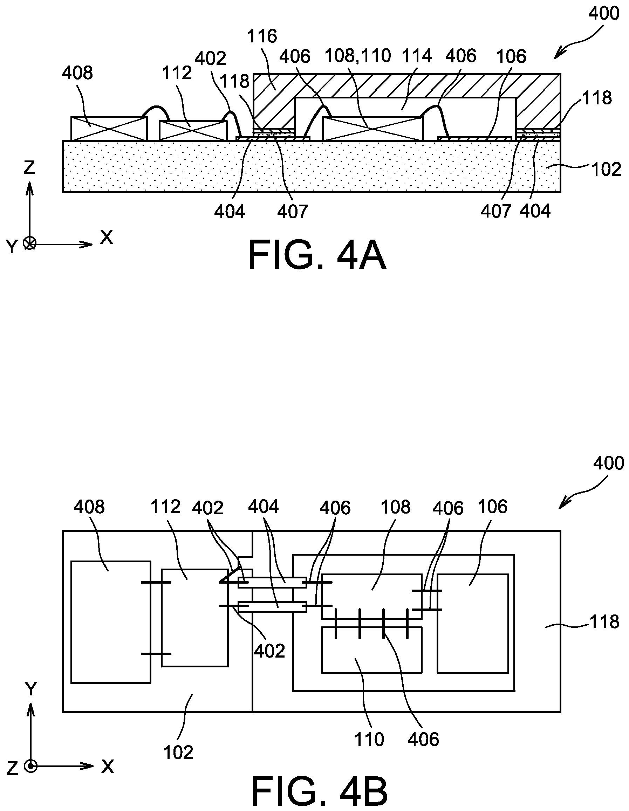

Comme pour le dispositif 100, le capot 116 est relié électriquement à l'un des potentiels électriques de l'alimentation 112, via le cordon de scellement 118. Ainsi, sur l'exemple de la figure 3, une piste électriquement conductrice 302 relie électriquement l'un des potentiels électriques de l'alimentation 112 au cordon de scellement 118, cette piste conductrice 302 étant disposée à l'extérieur de la cavité 114. Cette piste électriquement conductrice est par exemple réalisée à partir de la ou des mêmes couches métalliques servant à réaliser les autres pistes conductrices 114 et/ou l'antenne 106 et/ou le cordon de scellement 118. Au moins une des pistes conductrices 104 relie également l'alimentation électrique 112 au circuit intégré 108 afin d'alimenter électriquement le circuit intégré 108. Cette ou ces autres pistes électriques s'étendent depuis l'extérieur de la cavité 114 jusqu'à l'intérieur de la cavité 114, et sont isolées électriquement du cordon de scellement 118 par exemple en intercalant un matériau électriquement isolant entre ces pistes 104 et le cordon de scellement 118, comme cela sera décrit plus loin en liaison avec les figures 4A et 4B.

En variante, le dispositif 300 peut ne pas comporter le capteur 110, comme le dispositif 200. Dans ce cas, seuls l'antenne 106 et le circuit intégré 108 sont protégés par le capot 116 en étant disposés dans la cavité 114. De plus, au moins une partie des différentes liaisons électriques entre les composants du dispositif 300 peuvent être réalisées par des fils électriques 202, comme dans le dispositif 200.

Les figures 4A et 4B représentent un dispositif 400 selon un quatrième mode de réalisation. Comme représenté sur ces figures, la liaison électrique entre l'alimentation électrique 112 et le circuit intégré 108 est réalisée par deux fils électriques 402 reliés à deux pistes électriquement conductrices 404 s'étendant sur le substrat 102 entre l'intérieur et l'extérieur de la cavité 114 et qui sont isolées électriquement du cordon de scellement 118 grâce à une couche de matériau diélectrique 407 recouvrant complètement les pistes 404 et disposée entre les pistes 404 et le cordon de scellement 118. Cette couche de matériau diélectrique 407 est avantageusement planarisée de façon à ce que le cordon de scellement 118 ne soit pas discontinu. Un fil électrique 402 relie également l'un des potentiels électriques de l'alimentation 112 au cordon de scellement 118. Des fils électriques 406 assurent également les liaisons électriques entre l'antenne 106 et le circuit intégré 108, entre le circuit intégré 108 et les pistes conductrices 404, et entre le circuit intégré 108 et le capteur 110.

Dans ce quatrième mode de réalisation, l'alimentation électrique 112 est couplée à un dispositif de récupération d'énergie 408, se basant par exemple sur une conversion d'énergie photovoltaïque et/ou mécanique (par exemple par les vibrations subies par le dispositif) et/ou thermique (par exemple par un gradient de température sur le dispositif via effet Seebeck).

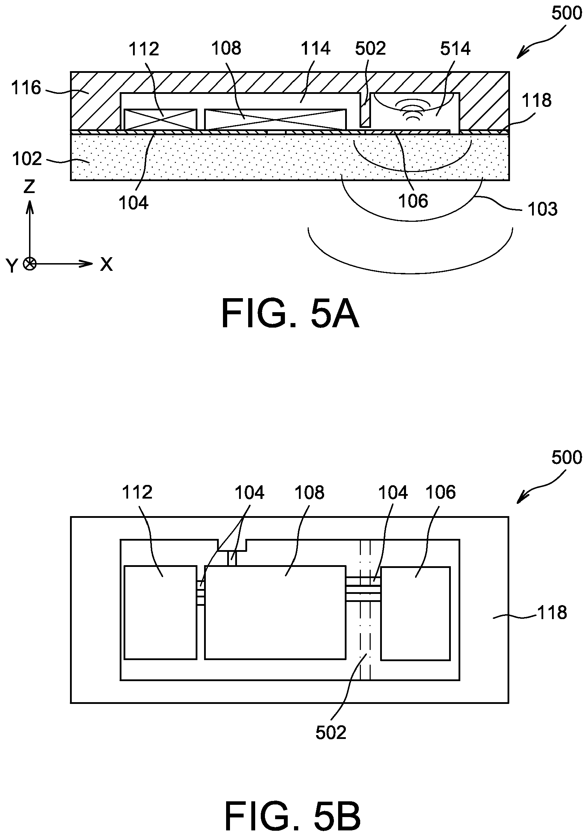

Les figures 5A et 5B représentent un dispositif 500 selon un cinquième mode de réalisation. Le dispositif 500 comporte une première cavité 114, formée entre le substrat 102 et le capot 116 dans laquelle sont encapsulés l'alimentation électrique 112 et le circuit intégré 108 (qui, dans ce mode de réalisation, remplie également le rôle du capteur 110), et une deuxième cavité 514 dans laquelle est encapsulée l'antenne 106. Une portion du capot 116 forme une séparation 502 entre les deux cavités 114, 514 et permet d'éviter toute perturbation électromagnétique des composants 112, 108 vers l'antenne 106. Cette séparation 502 est réalisée avantageusement par une portion du capot 116 car celui-ci est électriquement conducteur. La séparation 502 entre les deux cavités 114, 514 n'est pas nécessairement en contact avec le substrat 102. Dans ce cas, il n'est pas nécessaire de protéger, et notamment d'isoler électriquement, les pistes conductrices 104 reliant le circuit intégré 108 et l'antenne 106 du fait que la séparation 502 ne vient pas en contact avec ces pistes 104. En variante, la séparation 502 pourrait être réalisée à partir d'une portion de matériau n'appartenant pas au capot 116, c'est-à-dire qui est reportée contre le capot 116 afin de former un écran électromagnétique entre les deux cavités 114, 514. Enfin, dans le dispositif 500, le capot 116 est relié électriquement, via le cordon de scellement 118, à un potentiel électrique du circuit intégré 108.

Dans tous les modes de réalisation et variantes précédemment décrits, il est possible que la cavité 114 ne soit pas formée dans le capot 116, mais dans le substrat 102 (le capot correspondant dans ce cas à un substrat plan électriquement conducteur), ou en partie dans le substrat 102 et en partie dans le capot 116, ou encore qu'au moins une partie des parois latérales de la cavité 114 soient formées par des portions de matériau électriquement conducteur indépendantes du substrat 102 et du capot 116 et reliées électriquement, comme le capot 116, à un potentiel électrique de l'alimentation 112.

## Revendications

1. Dispositif microélectronique (100 - 500) de transmission sans fil, comprenant au moins :
- un premier substrat (102) apte à être traversé par des ondes radio (103) destinées à être émises par le dispositif microélectronique (100 - 500) et comprenant du silicium,
- une antenne (106),
- une alimentation électrique (112),
- un circuit intégré (108), relié électriquement à l'antenne (106) et à l'alimentation électrique (112), et apte à transmettre à l'antenne (106) des signaux électriques destinés à être émis par l'antenne (106) sous la forme desdites ondes radio (103),
- un capot (116) solidarisé au premier substrat (102) et formant, avec le premier substrat (102), au moins une cavité (114) dans laquelle sont disposés l'antenne (106) et le circuit intégré (108), le capot (116) comprenant un deuxième substrat comportant du silicium dopé tel qu'il forme un matériau électriquement conducteur, relié électriquement à un potentiel électrique de l'alimentation électrique (112) et/ou du circuit intégré (108), et apte à former un réflecteur vis-à-vis des ondes radio (103) destinées à être émises par l'antenne (106).

2. Dispositif (500) selon la revendication 1, dans lequel le circuit intégré (108) et l'antenne (106) sont disposés dans deux cavités distinctes (114, 514) formées entre le capot (116) et le substrat (102).

3. Dispositif (100 - 500) selon l'une des revendications précédentes, dans lequel l'alimentation électrique (112) comporte au moins une microbatterie et/ou est disposée dans la cavité (114) ou une des cavités (114, 514).

4. Dispositif (100 - 500) selon l'une des revendications précédentes, dans lequel les liaisons électriques entre le circuit intégré (108) et l'antenne (106), entre le circuit intégré (108) et l'alimentation électrique (112), et entre le capot (116) et l'alimentation électrique (112), comportent des fils (202, 402, 406) et/ou des pistes électriquement conductrices (104, 302, 404) disposées sur le premier substrat (102).

5. Dispositif (100, 300 - 500) selon la revendication 4, dans lequel les pistes électriquement conductrices (104, 302, 404) comprennent au moins un matériau électriquement conducteur similaire à au moins un matériau électriquement conducteur de l'antenne (106).

6. Dispositif (100 - 500) selon l'une des revendications précédentes, dans lequel les parois latérales de la cavité (114) sont formées par le capot (116).

7. Dispositif (100 - 500) selon l'une des revendications précédentes, dans lequel le capot (116) est solidarisé au premier substrat (102) par au moins un cordon de scellement (118) comprenant au moins un matériau électriquement conducteur.

8. Dispositif (100 - 500) selon la revendication 7, dans lequel l'alimentation électrique (112) et/ou le circuit intégré (108) est relié électriquement au cordon de scellement (118) qui est en contact avec le capot (116).

9. Dispositif (100 - 500) selon l'une des revendications 7 ou 8, dans lequel le cordon de scellement (118) comprend au moins un matériau métallique similaire à au moins un matériau métallique de l'antenne (106).

10. Dispositif (100, 300 - 500) selon l'une des revendications précédentes, comportant en outre au moins un capteur (110) disposé dans la cavité (114) ou une des cavités (114, 514) et relié électriquement au circuit intégré (108) tel que le capteur (110) soit apte à transmettre au moins un signal de mesure au circuit intégré (108), au moins une partie des signaux électriques transmis par le circuit intégré (108) à l'antenne (106) étant fonction du signal de mesure transmis au circuit intégré (108) par le capteur (110).

11. Dispositif (100 - 500) selon l'une des revendications précédentes, comportant en outre au moins un dispositif de récupération d'énergie (408) couplé électriquement à l'alimentation électrique (112).

12. Procédé de réalisation d'un dispositif microélectronique (100 - 500) de transmission sans fil, comprenant au moins les étapes de :
- intégration, sur un premier substrat (102) apte à être traversé par des ondes radio (103) destinées à être émises par le dispositif microélectronique (100 - 500) et comprenant du silicium, d'une antenne (106), d'une alimentation électrique (112), et d'un circuit intégré (108) relié électriquement à l'antenne (106) et à l'alimentation électrique (112), et apte à transmettre à l'antenne (106) des signaux électriques destinés à être émis par l'antenne sous la forme desdites ondes radio (103),
- solidarisation d'un capot (116) au premier substrat (102), formant au moins une cavité (114) dans laquelle sont disposés l'antenne (106) et le circuit intégré (108), le capot (116) comprenant un deuxième substrat de silicium dopé tel qu'il forme un matériau électriquement conducteur, relié électriquement à un potentiel électrique de l'alimentation électrique (112) et/ou du circuit intégré (108), et apte à former un réflecteur vis-à-vis des ondes radio (103) destinées à être émises par l'antenne (106).

13. Procédé selon la revendication 12, comportant au moins, avant l'intégration de l'alimentation électrique (112) et du circuit intégré (108), des étapes de dépôt, photolithographie et gravure d'au moins une couche électriquement conductrice sur le premier substrat (102), formant l'antenne (106) et des pistes électriquement conductrices (104, 302, 404), le circuit intégré (108) et l'alimentation électrique (112) étant reliés à au moins une partie des pistes électriquement conductrices (104, 302, 404) par des microbilles ou des liaisons filaires, les pistes électriquement conductrices (104, 302, 404) formant au moins une partie des liaisons électriques entre le circuit intégré (108) et l'antenne (106), entre le circuit intégré (108) et l'alimentation électrique (112), et entre le capot (116) et l'alimentation électrique (112) et/ou le circuit intégré (108).

14. Procédé selon la revendication 13, dans lequel les étapes de dépôt, photolithographie et gravure de ladite au moins une couche électriquement conductrice sur le premier substrat (102) forment également au moins une partie d'un cordon de scellement (118), le capot (116) étant solidarisé au premier substrat (102) par le cordon de scellement (118).

15. Procédé selon l'une des revendications 12 à 14, comportant en outre l'intégration d'un capteur (110) tel qu'il soit disposé dans la cavité (114) et relié électriquement au circuit intégré (108), le capteur (110) étant apte à transmettre au moins un signal de mesure au circuit intégré (108), au moins une partie des signaux électriques transmis par le circuit intégré (108) à l'antenne (106) étant fonction du signal de mesure transmis au circuit intégré (108) par le capteur (110).

16. Procédé selon l'une des revendications 12 à 15, comportant en outre au moins l'intégration d'un dispositif de récupération d'énergie (408) couplé électriquement à l'alimentation électrique (112).

## Patentansprüche

1. Mikroelektronische Vorrichtung (100-500) zur drahtlosen Übertragung, umfassend wenigstens:
- ein erstes Substrat (102), das dazu ausgelegt ist, von Funkwellen (103) durchsetzt zu werden, die durch die mikroelektronische Vorrichtung (100-500) emittiert werden sollen, und das Silizium umfasst,
- eine Antenne (106),
- eine elektrische Versorgung (112),
- eine integrierte Schaltung (108), die elektrisch mit der Antenne (106) und mit der elektrischen Versorgung (112) verbunden ist, und die dazu ausgelegt ist, zu der Antenne (106) elektrische Signale zu übertragen, die durch die Antenne (106) in Form der Funkwellen (103) emittiert werden sollen,
- eine Kuppel (116), die mit dem ersten Substrat (102) verbunden ist und zusammen mit dem ersten Substrat (102) wenigstens einen Hohlraum (114) bildet, in dem die Antenne (106) und die integrierte Schaltung (108) angeordnet sind, wobei die Kuppel (116) ein zweites Substrat umfasst, das dotiertes Silizium derart umfasst, dass es ein elektrisch leitendes Material bildet, das elektrisch mit einem elektrischen Potential der elektrischen Versorgung (112) und/oder der integrierten Schaltung (108) verbunden ist, und das dazu ausgelegt ist, einen Reflektor hinsichtlich der Funkwellen (103) zu bilden, die durch die Antenne (106) emittiert werden sollen.

2. Vorrichtung (500) nach Anspruch 1, bei der die integrierte Schaltung (108) und die Antenne (106) in zwei verschiedenen Hohlräumen (114, 514) angeordnet sind, die zwischen der Kuppel (116) und dem Substrat (102) gebildet sind.

3. Vorrichtung (100-500) nach einem der vorhergehenden Ansprüche, bei der die elektrische Versorgung (112) wenigstens eine Mikrobatterie umfasst und/oder in dem Hohlraum (114) oder einem der Hohlräume (114, 514) angeordnet ist.

4. Vorrichtung (100-500) nach einem der vorhergehenden Ansprüche, bei der die elektrischen Verbindungen zwischen der integrierten Schaltung (108) und der Antenne (106), zwischen der integrierten Schaltung (108) und der elektrischen Versorgung (112), und zwischen der Kuppel (116) und der elektrischen Versorgung (112) Drähte (202, 402, 406) und/oder elektrisch leitende Bahnen (104, 302, 404) umfassen, die auf dem ersten Substrat (102) angeordnet sind.

5. Vorrichtung (100, 300-500) nach Anspruch 4, bei der die elektrisch leitenden Bahnen (104, 302, 404) wenigstens ein elektrisch leitendes Material umfassen, das ähnlich wenigstens einem elektrisch leitenden Material der Antenne (106) ist.

6. Vorrichtung (100-500) nach einem der vorhergehenden Ansprüche, bei der die Seitenwände des Hohlraums (114) durch die Kuppel (116) gebildet sind.

7. Vorrichtung (100-500) nach einem der vorhergehenden Ansprüche, bei der die Kuppel (116) mit dem ersten Substrat (102) durch wenigstens einen Versiegelungsgürtel (118) verbunden ist, der wenigstens ein elektrisch leitendes Material umfasst.

8. Vorrichtung (100-500) nach Anspruch 7, bei der die elektrische Versorgung (112) und/oder die integrierte Schaltung (108) elektrisch mit dem Versiegelungsgürtel (118) verbunden ist, der in Kontakt mit der Kuppel (116) ist.

9. Vorrichtung (100-500) nach einem der Ansprüche 7 oder 8, bei der der Versiegelungsgürtel (118) wenigstens ein metallisches Material umfasst, das ähnlich wenigstens einem metallischen Material der Antenne (106) ist.

10. Vorrichtung (100, 300-500) nach einem der vorhergehenden Ansprüche, ferner umfassend wenigstens einen Sensor (110), der in dem Hohlraum (114) oder einem der Hohlräume (114, 514) angeordnet und elektrisch mit der integrierten Schaltung (108) verbunden ist, derart, dass der Sensor (110) dazu ausgelegt ist, wenigstens ein Messsignal an die integrierte Schaltung (108) zu übertragen, wobei wenigstens ein Teil der elektrischen Signale, die durch die integrierte Schaltung (108) an die Antenne (106) übertragen werden, eine Funktion des Messsignals ist, das durch den Sensor (110) an die integrierte Schaltung (108) übertragen wird.

11. Vorrichtung (100-500) nach einem der vorhergehenden Ansprüche, ferner umfassend wenigstens eine Energierückgewinnungsvorrichtung (408), die elektrisch mit der elektrischen Versorgung (112) gekoppelt ist.

12. Verfahren zur Herstellung einer mikroelektronischen Vorrichtung (100-500) zur drahtlosen Übertragung, umfassend wenigstens die Schritte:
- Integrieren, auf einem ersten Substrat (102), das dazu ausgelegt ist, durch Funkwellen (103) durchsetzt zu werden, die durch die mikroelektronische Vorrichtung (100-500) emittiert werden sollen, und das Silizium umfasst, einer Antenne (106), einer elektrischen Versorgung (112) und einer integrierten Schaltung (108), die elektrisch mit der Antenne (106) und mit der elektrischen Versorgung (112) verbunden ist, und dazu ausgelegt ist, an die Antenne (106) elektrische Signale zu übertragen, die durch die Antenne (106) in Form der Funkwellen (103) emittiert werden sollen,
- Verbinden einer Kuppel (116) mit dem ersten Substrat (102), was wenigstens einen Hohlraum (114) bildet, in dem die Antenne (106) und die integrierte Schaltung (108) angeordnet sind, wobei die Kuppel (116) ein zweites Substrat aus dotiertem Silizium derart umfasst, dass es ein elektrisch leitendes Material bildet, das elektrisch mit einem elektrischen Potential der elektrischen Versorgung (112) und/oder der integrierten Schaltung (108) verbunden und dazu ausgelegt ist, einen Reflektor hinsichtlich der Funkwellen (103) zu bilden, die durch die Antenne (106) emittiert werden sollen.

13. Verfahren nach Anspruch 12, umfassend wenigstens vor der Integration der elektrischen Versorgung (112) und der integrierten Schaltung (108) Schritte zur Aufbringung, Fotolithografie und Ätzung wenigstens einer elektrisch leitenden Schicht auf dem ersten Substrat (102) zur Bildung der Antenne (106) und von elektrisch leitenden Bahnen (104, 302, 404), wobei die integrierte Schaltung (108) und die elektrische Versorgung (112) mit wenigstens einem Teil der elektrisch leitenden Bahnen (104, 302, 404) durch Mikrokügelchen oder Drahtverbindungen verbunden sind, wobei die elektrisch leitenden Bahnen (104, 302, 404) wenigstens einen Teil der elektrischen Verbindungen zwischen der integrierten Schaltung (108) und der Antenne (106), zwischen der integrierten Schaltung (108) und der elektrischen Versorgung (112) und zwischen der Kuppel (116) und der elektrischen Versorgung (112) und/oder der integrierten Schaltung (108) bilden.

14. Verfahren nach Anspruch 13, bei dem die Schritte der Aufbringung, Fotolithografie und Ätzung der wenigstens einen elektrisch leitenden Schicht auf dem ersten Substrat (102) ferner wenigstens einen Teil eines Versiegelungsgürtels (118) bilden, wobei die Kuppel (116) durch den Versiegelungsgürtel (118) mit dem ersten Substrat (102) verbunden wird.

15. Verfahren nach einem der Ansprüche 12 bis 14, ferner umfassend die Integration eines Sensors (110) derart, dass er in dem Hohlraum (114) angeordnet und elektrisch mit der integrierten Schaltung (108) verbunden ist, wobei der Sensor (110) dazu ausgelegt ist, wenigstens ein Messsignal an die integrierte Schaltung (108) zu übertragen, wobei wenigstens ein Teil der elektrischen Signale, die durch die integrierte Schaltung (108) an die Antenne (106) übertragen werden, eine Funktion des Messsignals ist, das durch den Sensor (110) an die integrierte Schaltung (108) übertragen wird.

16. Verfahren nach einem der Ansprüche 12 bis 15, ferner umfassend wenigstens die Integration einer Energierückgewinnungsvorrichtung (408), die elektrisch mit der elektrischen Versorgung (112) gekoppelt ist.

## Claims

1. A microelectronic wireless transmission device (100 - 500) including at least:
- a first substrate (102) able to be crossed by radio waves (103) intended to be emitted by the microelectronic device (100 - 500) and comprising silicon,
- an antenna (106),
- an electrical power supply (112),
- an integrated circuit (108), electrically connected to the antenna (106) and to the electrical power supply (112), and able to transmit to the antenna (106) electrical signals intended to be emitted by the antenna (106) in the form of the said radio waves (103),
- a cap (116) rigidly connected to the first substrate (102) and forming, with the first substrate (102), at least one cavity (114) in which the antenna (106) and the integrated circuit (108) are positioned, where the cap (116) comprises a second substrate comprising doped silicon such that it forms an electrically conductive material connected electrically to an electrical potential of the electrical power supply (112) and/or of the integrated circuit (108), and able to form a reflector towards the radio waves (103) intended to be emitted by the antenna (106).

2. The device (500) according to claim 1, in which the integrated circuit (108) and the antenna (106) are positioned in two separated cavities (114, 514) formed between the cap (116) and the substrate (102).

3. The device (100 - 500) according to one of previous claims, in which the electrical power supply (112) includes at least one micro battery and/or is positioned in the cavity (114) or one of the cavities (114, 514).

4. The device (100 - 500) according to one of previous claims, in which the electrical connections between the integrated circuit (108) and the antenna (106), between the integrated circuit (108) and electrical power supply (112), and between the cap (116) and the electrical power supply (112), include wires (202, 402, 406) and/or electrically conductive tracks (104, 302, 404) positioned on the first substrate (102).

5. The device (100, 300 - 500) according to claim 4, in which the electrically conductive tracks (104, 302, 404) comprise at least one electrically conductive material similar to the at least one electrically conductive material of the antenna (106).

6. The device (100 - 500) according to one of previous claims, in which the side walls of the cavity (114) are formed by the cap (116).

7. The device (100 - 500) according to one of previous claims, in which the cap (116) is rigidly connected to the first substrate (102) by at least one sealing bead (118) comprising at least one electrically conductive material.

8. The device (100 - 500) according to claim 7, in which the electrical power supply (112) and/or the integrated circuit (108) is electrically connected to the sealing bead (118) which is in contact with the cap (116).

9. The device (100 - 500) according to one of claims 7 or 8, in which the sealing bead (118) comprises at least one metal material similar to at least one metal material of the antenna (106).

10. The device (100, 300 - 500) according to one of previous claims, also including at least one sensor (110) positioned in the cavity (114) or one of the cavities (114, 514) and electrically connected to the integrated circuit (108) such that the sensor (110) is able to transmit at least one measuring signal to the integrated circuit (108), where at least a proportion of the electrical signals transmitted by the integrated circuit (108) to the antenna (106) is dependent on the measuring signal transmitted to the integrated circuit (108) by the sensor (110).

11. The device (100 - 500) according to one of previous claims, also including at least one energy recovery device (408) electrically coupled to the electrical power supply (112).

12. A method for producing a microelectronic wireless transmission device (100 - 500), including at least the following steps:
- integration, on a first substrate (102) able to be crossed by radio waves (103) intended to be emitted by the microelectronic device (100 - 500) and comprising silicon, of an antenna (106), an electrical power supply (112) and an integrated circuit (108) electrically connected to the antenna (106) and to the electrical power supply (112), and able to transmit to the antenna (106) electrical signals intended to be emitted by the antenna in the form of the said radio waves (103),
- rigid connection of a cap (116) to the first substrate (102), forming at least one cavity (114) in which the antenna (106) and the integrated circuit (108) are positioned, where the cap (116) comprises a second substrate comprising doped silicon such that it forms an electrically conductive material connected electrically to an electrical potential of the electrical power supply (112) and/or of the integrated circuit (108), and able to form a reflector towards the radio waves (103) intended to be emitted by the antenna (106).

13. The method according to claim 12, including at least, before the electrical power supply (112) and the integrated circuit (108) are integrated, steps of deposition, photolithography and etching of at least one electrically conductive layer on the first substrate (102), forming the antenna (106) and electrically conductive tracks (104, 302, 404), where the integrated circuit (108) and the electrical power supply (112) are connected to at least one portion of the electrically conductive tracks (104, 302, 404) by microbeads or wired connections, where the electrically conductive tracks (104, 302, 404) form at least a proportion of the electrical connections between the integrated circuit (108) and the antenna (106), between the integrated circuit (108) and the electrical power supply (112), and between the cap (116) and the electrical power supply (112) and/or the integrated circuit (108).

14. The method according to claim 13, in which the steps of deposition, photolithography and etching of the said at least one electrically conductive layer on the first substrate (102) also form at least a portion of a sealing bead (118), where the cap (116) is rigidly connected to the first substrate (102) by the sealing bead (118).

15. The method according to one of claims 12 to 14, also including incorporation of a sensor (110) such that it is positioned in the cavity (114) and electrically connected to the integrated circuit (108), where the sensor (110) is able to transmit at least one measuring signal to the integrated circuit (108), and where at least a proportion of the electrical signals transmitted by the integrated circuit (108) to the antenna (106) is dependent on the measuring signal transmitted to the integrated circuit (108) by the sensor(110).

16. The method according to one of claims 12 to 15, also including at least the incorporation of an energy recovery device (408) electrically coupled to the electrical power supply (112).
